# FASCICULE DE BREVET EUROPEEN

(11) **EP 2 702 362 B1**
(45) Date de publication et mention de la délivrance du brevet: **14.02.2018**
(21) Numéro de dépôt: 12713767.7
(22) Date de dépôt: 16.04.2012
(51) Int. Cl.: G01D 5/00, H01H 36/00

(54) **DISPOSITIF DE DETECTION ELECTRONIQUE MODULAIRE**
MODULARE, ELEKTRONISCHE ABTASTVORRICHTUNG
MODULAR ELECTRONIC SENSING DEVICE

(30) Priorité: 26.04.2011 FR 1153555
(43) Date de publication de la demande: 05.03.2014
(73) Titulaire: Airbus Group SAS, 31700 Blagnac (FR)
(72) Inventeur: MOREAU, Katell, 75015 Paris (FR); DANTIN, Benoit, 93800 Epinay Sur Seine (FR); CHEVASSUS, Nicolas, 92370 Chaville (FR)
(74) Mandataire: Ipside
(86) Numéro de dépôt international: PCT/EP2012/056929
(87) Numéro de publication internationale: WO 2012/146503

(56) Documents cités:
- EP-A2- 2 031 620
- WO-A2-2009/111687
- US-A1- 2009 064 809
- US-B1- 6 587 056

## Description

### Domaine de l'invention

La présente invention se rapporte au domaine de l'électronique.

La présente invention se rapporte plus particulièrement à un dispositif de détection électronique modulaire.

### Etat de la technique

L'installation des systèmes électroniques sur des aéronefs nécessite beaucoup de temps. De plus, ce type d'opérations se trouve sur le chemin critique de l'assemblage de l'aéronef.

La quantité installée de câbles représente une masse importante et cela a un impact sur les performances de l'aéronef.

De plus, l'augmentation des systèmes électriques accroît localement la densité des câbles, notamment dans la zone cockpit et dans la soute électronique des aéronefs. Ceci impose des contraintes d'allocation spatiale fortes qui peuvent aller jusqu'à modifier l'aérodynamique pour pouvoir installer l'ensemble de ces câbles.

Enfin, pour plus de flexibilité et de disponibilité, les utilisateurs demandent de pouvoir reconfigurer dynamiquement leur aéronef entre différentes missions et de minimiser les temps de maintenance.

Actuellement, les panneaux de commande sont principalement constitués de sélecteurs rotatifs, de voyants et d'interrupteurs reliés fil à fil avec l'élément qu'ils commandent. Ce type d'architecture nécessite donc l'emploi d'un grand nombre de câbles.

On constate depuis quelques temps l'introduction de bus de communication dans les aéronefs, ce qui réduit sensiblement le nombre de câbles.

Cependant, même sur les avions récents, ou en cours de développement, les signaux critiques ne sont pas multiplexés du fait du niveau de fiabilité requis. La quantité d'éléments de communication point à point reste importante.

Enfin, les solutions actuelles ne permettent pas facilement la reconfiguration du fait de la quantité de câbles à modifier et du couplage commande mécanique / commutation électrique. Le document US 6 587 056 B1 décrit un tel dispositif.

### Exposé de l'invention

La présente invention entend remédier aux inconvénients de l'art antérieur en proposant un dispositif de détection électronique alliant modularité et généricité.

A cet effet, la présente invention concerne, dans son acception la plus générale, un dispositif de détection électronique modulaire et selon la revendication 1. Ces capteurs sont toujours positionnés de la même façon, quelque soit l'actionneur mécanique choisi, ce qui en fait une électronique générique et modulaire.

L'architecture choisie est toujours la même: le choix des composants et leurs positions géographiques relatives.

Le dispositif selon la présente invention permet ainsi :
- Par l'électronique modulaire, de réduire le temps de reconfiguration de l'aéronef ;
- Par la redondance et l'architecture des composants électroniques, de réduire les temps de recherche de pannes et de maintenance ; et
- Par le multiplexage et la modularité, de réduire le câblage, donc la masse embarquée, le temps d'installation et l'espace alloué associés.

Selon un mode de réalisation, ledit actionneur mécanique est un bouton poussoir.

Selon un mode de réalisation, ledit actionneur mécanique est un bouton rotatif : sélecteur rotatif ou potentiomètre.

Selon un mode de réalisation, ledit actionneur mécanique est un bouton interrupteur à deux positions.

Selon un mode de réalisation, ledit actionneur mécanique est un bouton interrupteur à trois positions.

Selon une variante, lesdits capteurs de position sont des capteurs magnétiques.

Selon une autre variante, lesdits capteurs de position sont des capteurs à effet Hall.

Selon une autre variante, lesdits capteurs de position sont des capteurs optiques.

La présente invention se rapporte également à un aéronef comprenant le dispositif évoqué ci-dessus.

Les avantages du dispositif selon la présente invention sont les suivants :
- Modularité de la détection (personnalisation tardive du panneau, reconfiguration rapide du panneau) ;
- Généricité du dispositif de détection : il couvre toutes les fonctions ;
- Optimisation de la hauteur du panneau ;
- Multiplexage avec de l'électronique simple, permettant un niveau de fiabilité adéquat (diminution du câblage) ;
- Dispositif utilisable avec n'importe quel bus ou protocole (CAN, Ethernet, ...) ;
- Détection sans contact permettant d'augmenter le nombre d'utilisations du dispositif ;
- Monitoring permanent de l'état du système grâce à l'électronique installée ; et
- Coût optimisé.

### Brève description des dessins

On comprendra mieux l'invention à l'aide de la description, faite ci-après à titre purement explicatif, d'un mode de réalisation de l'invention, en référence aux Figures dans lesquelles :
- la Figure 1 est un schéma de principe du dispositif selon la présente invention ;
- les Figures 2a, 2b et 2c représentent le dispositif selon la présente invention ;
- les Figures 3a, 3b et 3c illustrent des exemples d'utilisation du dispositif selon la présente invention ; et
- la Figure 4 représente un exemple de regroupement de dispositifs selon la présente invention pour constitution d'un panneau.

### Description détaillée des modes de réalisation de l'invention

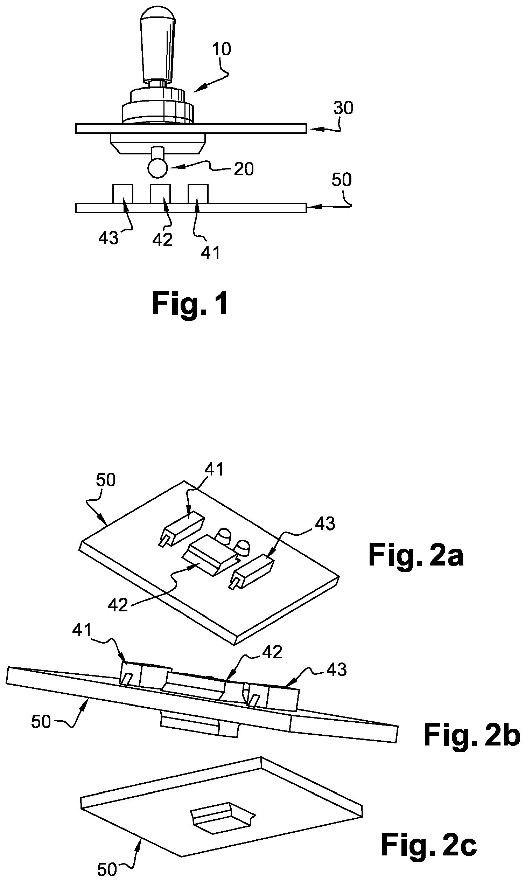

La Figure 1 est un schéma de principe du dispositif selon la présente invention.

Le dispositif de détection électronique modulaire selon la présente invention, illustré Figure 1, comporte :
- un actionneur mécanique 10 lié à une cible 20 au travers d'une face avant de panneau 30 ; et
- une pluralité de capteurs de position 41, 42 et 43 de ladite cible 20 liés à une carte de circuit imprimé 50.

Le principe ainsi proposé permet un découplage physique de la commande mécanique et de la détection / analyse de l'information ; et une détection et analyse des informations données par différents types d'actionneurs mécaniques (bouton poussoir, bouton rotatif, bouton interrupteur à deux ou trois positions, etc.) par une seule électronique modulaire.

Les capteurs peuvent être installés de part et d'autre d'un support type circuit imprimé, rigide, flexible ou flex-rigide, de manière unitaire (une empreinte par support) ou groupée (plusieurs empreintes par support).

Cette électronique s'intègre aisément, de par sa taille, sur une surface minimale compatible avec les exigences des panneaux de commande des aéronefs. Cette surface minimale est conditionnée par la distance entre deux actionneurs mécaniques (règles ergonomiques).

Afin d'activer le dispositif de détection, une cible solidaire de la partie actionneur mécanique est utilisée.

Afin de compléter l'électronique modulaire, la gravure de la face avant du panneau est également reconfigurable pour s'adapter à chaque fonction commandée par un interrupteur ou un voyant.

Les capteurs peuvent être de technologies variées : magnétique, à effet Hall, optique ...

La solution selon la présente invention peut être assemblée à grande échelle et à bas coût.

Cette solution permet une forte réduction des câblages, donc de la masse et du temps d'installation, et de l'encombrement du panneau (réduction par trois de la hauteur du panneau).

En ce qui concerne la face avant reconfigurable, le choix des technologies pouvant être employées est large : écrans LCD, OLED, PHOLED, etc.

Les Figures 2a, 2b et 2c représentent le dispositif selon la présente invention.

Sur chacune des Figures 2a à 2c, des capteurs de position 41, 42 et 43 liés à une carte de circuit imprimé 50 sont représentés.

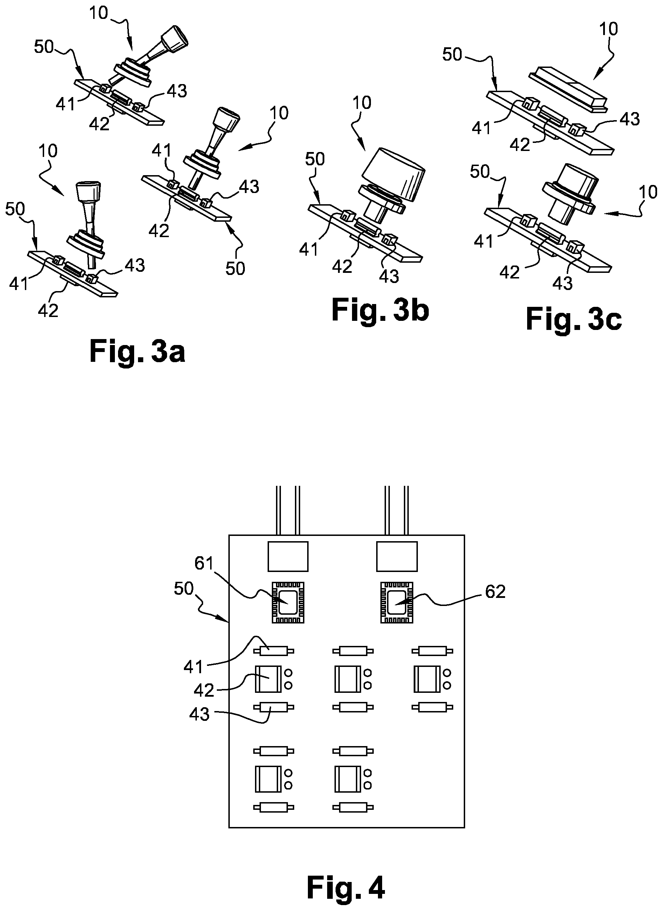

Les Figures 3a, 3b et 3c illustrent des exemples d'utilisation du dispositif selon la présente invention.

La Figure 3a représente un bouton interrupteur à deux et trois positions.

La Figure 3b illustre un potentiomètre et sélecteur rotatif.

La Figure 3c illustre deux exemples de boutons poussoirs.

Sur chacune des Figures 3a à 3c, un actionneur mécanique 10 et des capteurs de position 41, 42 et 43 liés à une carte de circuit imprimé 50 sont représentés.

La Figure 4 représente un exemple de regroupement de dispositifs selon la présente invention pour constitution d'un panneau. Dans cet exemple, on trouve deux alimentations et deux ports de communication, un niveau de protection Δ*V*
et communiquant avec chaque capteur, et cinq empreintes modulaires, avec chaque capteur alimenté par les deux sources et communiquant avec les deux microcontrôleurs.

La présente invention peut être utilisée pour l'ensemble des panneaux de commande installés à bord des aéronefs, notamment pour des panneaux optionnels ou dédiés à des missions particulières.

Pour une fonctionnalité et une disponibilité équivalentes à celles des panneaux actuels, le dispositif selon la présente invention permet d'obtenir une réduction :
- de la masse embarquée et de l'allocation spatiale ;
- des temps d'installation ;
- des temps de recherche de panne ;
- des temps de maintenance ; et
- des temps de reconfiguration des aéronefs entre deux types de mission.

## Revendications

1. Dispositif de détection électronique modulaire et générique, comportant :
• un actionneur mécanique (10) lié à une cible (20) au travers d'une face avant de panneau (30) ; et
• une pluralité de capteurs de position (41, 42, 43) de ladite cible (20) liés à une carte de circuit imprimé (50) ;
ledit actionneur mécanique (10) est un bouton interrupteur à deux ou trois positions et caractérisé et en ce que :
• ladite cible (20) est disposée entre ledit panneau (30) et ladite carte de circuit imprimé (50) ; et
• ladite cible (20) étant mécaniquement découplée de ladite pluralité de capteurs de position (41, 42, 43).

2. Dispositif selon la revendication 1, **caractérisé en ce que** ledit actionneur mécanique (10) est un bouton poussoir.

3. Dispositif selon la revendication 1, **caractérisé en ce que** ledit actionneur mécanique (10) est un bouton rotatif : sélecteur rotatif ou potentiomètre.

4. Dispositif selon la revendication 1, **caractérisé en ce que** lesdits capteurs de position (41, 42, 43) sont des capteurs magnétiques.

5. Dispositif selon la revendication 1, **caractérisé en ce que** lesdits capteurs de position (41, 42, 43) sont des capteurs à effet Hall.

6. Dispositif selon la revendication 1, **caractérisé en ce que** lesdits capteurs de position (41, 42, 43) sont des capteurs optiques.

7. Aéronef comprenant un dispositif selon l'une des revendications précédentes.

## Patentansprüche

1. Modulare und generische elektronische Erkennungsvorrichtung, umfassend:
• einen mechanischen Aktuator (10), der mit einem Ziel (20) über eine vordere Plattenfläche (30) verbunden ist; und
• eine Vielzahl von Positionsfühlern (41, 42, 43) des Ziels (20), die mit einer gedruckten Schaltplatte (50) verbunden sind;
wobei der mechanische Aktuator (10) ein Unterbrecherknopf mit zwei oder drei Positionen ist, und **dadurch gekennzeichnet, dass**:
• das Ziel (20) zwischen der Platte (30) und der gedruckten Schaltplatte (50) angeordnet ist; und
• das Ziel (20) mechanisch von der Vielzahl von Positionsfühlern (41, 42, 43) entkoppelt ist.

2. Vorrichtung nach Anspruch 1, **dadurch gekennzeichnet, dass** der mechanische Aktuator (10) ein Druckknopf ist.

3. Vorrichtung nach Anspruch 1, **dadurch gekennzeichnet, dass** der mechanische Aktuator (10) ein Drehknopf ist: Drehschalter oder Potentiometer.

4. Vorrichtung nach Anspruch 1, **dadurch gekennzeichnet, dass** die Positionsfühler (41, 42, 43) Magnetsensoren sind.

5. Vorrichtung nach Anspruch 1, **dadurch gekennzeichnet, dass** die Positionsfühler (41, 42, 43) Hall-Effekt-Sensoren sind.

6. Vorrichtung nach Anspruch 1, **dadurch gekennzeichnet, dass** die Positionsfühler (41, 42, 43) optische Sensoren sind.

7. Flugzeug, umfassend eine Vorrichtung nach einem der vorhergehenden Ansprüche.

## Claims

1. Generic and modular electronic detection device, including:
• a mechanical actuator (10) linked to a target (20) through a front face of a panel (30); and
• a plurality of position sensors (41, 42, 43) for detecting the position of said target (20) that are linked to a printed circuit board (50);
said mechanical actuator (10) is a switch button having two or three positions and is **characterized in that**:
• said target (20) is positioned between said panel (30) and said printed circuit board (50); and
• said target (20) being mechanically decoupled from said plurality of position sensors (41, 42, 43) .

2. Device according to Claim 1, **characterized in that** said mechanical actuator (10) is a pushbutton.

3. Device according to Claim 1, **characterized in that** said mechanical actuator (10) is a rotary button: a rotary selector or potentiometer.

4. Device according to Claim 1, **characterized in that** said position sensors (41, 42, 43) are magnetic sensors.

5. Device according to Claim 1, **characterized in that** said position sensors (41, 42, 43) are Hall effect sensors.

6. Device according to Claim 1, **characterized in that** said position sensors (41, 42, 43) are optical sensors.

7. Aircraft comprising a device according to one of the preceding claims.
